# FASCICULE DE BREVET EUROPEEN

(11) **EP 2 271 790 B1**
(45) Date de publication et mention de la délivrance du brevet: **15.06.2016**
(21) Numéro de dépôt: 09742217.4
(22) Date de dépôt: 22.04.2009
(51) Int. Cl.: C23C 16/455

(54) **DISPOSITIF ET PROCEDE DE TRAITEMENT CHIMIQUE EN PHASE VAPEUR**
VORRICHTUNG UND VERFAHREN FÜR GASPHASENBEHANDLUNG
DEVICE AND PROCESS FOR CHEMICAL VAPOR PHASE TREATMENT

(30) Priorité: 28.04.2008 FR 0802375
(43) Date de publication de la demande: 12.01.2011
(73) Titulaire: ALTATECH Semiconductor, 38330 Montbonnot-Saint-Martin (FR)
(72) Inventeur: BOREAN, Christophe, F-38660 Le Touvet (FR); DELCARRI, Jean-Luc, F-38330 Saint Ismier (FR)
(74) Mandataire: Regimbeau
(86) Numéro de dépôt international: PCT/FR2009/000479
(87) Numéro de publication internationale: WO 2009/136019

(56) Documents cités:
- EP-A- 1 033 743
- WO-A-03/064059
- WO-A-2005/111267
- US-A- 5 595 606
- US-A1- 2001 042 799
- US-A1- 2003 143 328
- US-A1- 2004 071 897
- US-A1- 2005 229 848

## Description

L'invention relève du domaine de la fabrication des circuits intégrés ou des microsystèmes et plus particulièrement des équipements de dépôt chimique en phase vapeur.

Les circuits intégrés ou les microsystèmes sont fabriqués à partir de plaquettes ou substrats, généralement en silicium ou un autre matériau semiconducteur, qui subissent une succession d'étapes de dépôt de couches minces de divers matériaux, de masquage et de lithographie de ces couches puis de gravure de ces mêmes couches. Entre ces étapes de fabrication des éléments actifs des dispositifs, viennent s'intercaler des étapes de nettoyage des surfaces ainsi que des étapes d'inspection où la qualité des procédés de fabrication est examinée.

La présente invention s'intéresse notamment aux équipements de dépôt des couches constitutives des circuits intégrés et des microsystèmes et plus particulièrement aux équipements de dépôt chimique en phase vapeur.

Divers types de dépôts sont employés dans les technologies de fabrication des circuits intégrés et des microsystèmes : les dépôts dits physiques ( pulvérisation, évaporation ) et les dépôts dits chimiques : dépôt chimique en phase vapeur, dépôt par couches atomiques, dépôt électrochimique, pour ne citer que les principales catégories qui se subdivisent elles-mêmes en plusieurs sous-catégories.

Les dépôts physiques, qui concernent plus particulièrement le dépôt de couches métalliques, se font dans des gammes de pression allant de quelques nanobars à quelques microbars. Ils présentent l'avantage d'être relativement simples à mettre en oeuvre puisque ils n'utilisent que des gaz neutres pour la réalisation des dépôts. En revanche, de par leur nature directionnelle, ils présentent l'inconvénient de ne pas recouvrir de manière uniforme des motifs présentant des surfaces horizontales et des surfaces verticales ou quasi-verticales telles que celles qui apparaissent lors de la fabrication de circuits intégrés et de microsystèmes.

En effet, le taux de couverture d'une surface par un dépôt physique est directement proportionnel à l'angle solide vu de cette surface. Il en résulte que les parties saillantes et les surfaces horizontales d'un motif sont recouvertes avec une épaisseur plus importante que les angles rentrants ou les surfaces verticales. Il en résulte donc une inhomogénéité des dépôts qui peut être préjudiciable au bon fonctionnement du dispositif électronique fabriqué.

Dans les dépôts chimiques, une adsorption, une chimisorption ou une réaction hétérogène se produit à la surface du substrat à recouvrir. Cette adsorption, chimisorption ou réaction se produit sur toutes les surfaces si les conditions adéquates de température, de pression et de concentration des réactifs sont réunies dans le cas d'un dépôt en phase vapeur. Il en résulte que les dépôts chimiques et en particulier les dépôts chimiques en phase vapeur recouvrent intrinsèquement de manière uniforme la surface des motifs constituant les circuits intégrés ou les microsystèmes. Cette caractéristique est particulièrement avantageuse dans les circuits ou microsystèmes récents où les motifs à recouvrir peuvent présenter des facteurs de forme (rapport entre la largeur et la hauteur du motif) très élevés.

Les systèmes de fabrication des circuits intégrés ou microsystèmes comprennent généralement une chambre de traitement comprenant un support pour le substrat dans la chambre.

Un ensemble de distribution de gaz, également connu sous le terme de douche ou « showerhead » en langue anglaise, fournit un ou plusieurs gaz de traitement à proximité du substrat. Les gaz peuvent être utilisés pour former un plasma. De tels procédés peuvent comprendre le dépôt chimique en phase vapeur (chemical vapor deposition ou CVD), le dépôt chimique en phase vapeur assisté par plasma (plasma enhanced chemical vapor deposition ou PECVD) pour déposer une couche sur le substrat ou encore une réaction de gravure pour enlever de la matière de la plaquette.

On connaît à cet égard les documents US 5 292 554, US 5 516 367 adaptés aux anciennes technologies de fabrication, WO 03/060185 et US 2006/21703.

La Demanderesse s'est rendu compte que les chambres de traitement connues étaient susceptibles de laisser se produire des réactions parasites entre plusieurs gaz en amont de l'ensemble de distribution de gaz. De telles réactions parasites peuvent déposer des solides sous forme pulvérulente en des endroits non souhaités. En outre, la pression en amont de l'ensemble de distribution de gaz étant plus élevée qu'à la surface du substrat à recouvrir, de telles réactions parasites en phase gazeuse sont favorisées.

Par ailleurs, la Demanderesse a identifié que les matériaux les plus récents dont l'utilisation est envisagée dans le domaine des circuits intégrés et des microsystèmes peuvent présenter des risques de colmatage des trous de l'ensemble de distribution des gaz.

L'invention vient améliorer la situation.

Le dispositif de traitement de substrats comprend une chambre à pression et température contrôlées, et un support de substrat. Le support est disposé dans la chambre. La chambre comprend plusieurs entrées de gaz, par exemple deux. Le dispositif comprend une pluralité de premiers canaux reliés à une première entrée de gaz et une pluralité de deuxièmes canaux reliés à une deuxième entrée de gaz. Les premiers et deuxièmes canaux débouchent dans la chambre. Ils sont répartis régulièrement dans la paroi supérieure de la chambre. Le dispositif comprend également un élément de chauffage capable de chauffer la paroi supérieure et un anneau d'évacuation de gaz disposé entre la paroi supérieure et le support de substrat. La paroi supérieure est conductrice électriquement et isolée par rapport au support de plaquette de la chambre de façon à pouvoir appliquer une tension entre la paroi supérieure et le support de plaquette.

L'élément de chauffage est disposé au-dessus de la paroi supérieure pour chauffer ladite paroi supérieure et les entrées. Le dispositif comprend un corps définissant une cavité sur une face et un couvercle fermant la cavité sur la face pour former la chambre. Le couvercle comprend une partie inférieure et une partie principale reposant sur la partie inférieure. La paroi supérieure est maintenue entre une surface inférieure de la partie principale du couvercle et l'anneau d'évacuation des gaz. La partie principale du couvercle comprend une concavité circulaire ménagée à partir de sa surface principale opposée à la chambre. L'élément de chauffage est disposé dans la concavité circulaire.

L'invention concerne également un procédé de traitement de substrats dans une chambre d'un dispositif tel que défini ci-avant, un substrat étant supportée par le support disposé dans la chambre. On chauffe des entrées de gaz à une température supérieure à une température de condensation, le chauffage pouvant être réalisé par un fluide caloporteur. On injecte des gaz par lesdites entrées, les gaz traversant la paroi supérieure de la chambre disposée sous les entrées, la traversée étant effectuée par des trous distincts selon la nature de gaz et pénétrant dans la chambre, les trous étant régulièrement répartis. Si l'on veut générer un plasma, on applique à la paroi supérieure une tension électrique à haute fréquence par rapport audit support.

La chambre peut former une enceinte dont la pression est régulée en dessous de la pression atmosphérique par l'intermédiaire d'un système de pompage d'une part et de régulation de pression d'autre part.

L'élément de chauffage, notamment par fluide caloporteur, permet de chauffer les gaz à une température convenable, dans lesdites entrées, par exemple une température permettant de limiter les phénomènes de condensation compte tenu du fait que la pression des gaz dans les entrées est légèrement supérieure à la pression des gaz dans la chambre. L'élément de chauffage peut être disposé au-dessus ou à l'intérieur de la paroi supérieure.

L'élément de chauffage, notamment par fluide caloporteur, permet également l'application d'une tension en vue de générer un plasma, en évitant de générer des interférences, ce qui ne serait pas le cas avec un chauffage de type électrique résistif. Alternativement, une lampe infrarouge peut être mise en oeuvre pour assurer le chauffage à distance du couvercle. Une résistance isolée peut aussi être utilisée, montée dans un boîtier isolant notamment en céramique.

Par ailleurs, l'application d'une tension entre la paroi supérieure et le support en vue de générer un plasma entre ces deux éléments, permet d'effectuer un nettoyage in-situ efficace de la chambre en introduisant des gaz choisis pour réagir avec les dépôts éventuellement présents à l'intérieur de la chambre. Les gaz de nettoyage sont choisis de telle façon que les produits de la réaction de ces gaz avec les dépôts soient volatils, et puissent ainsi être évacués par le pompage. Le dispositif et le procédé de traitement sont bien adaptés au dépôt de matériaux pour la fabrication de dispositifs microélectroniques, micro-électromécaniques, tels que par exemple non limitatif : Hf0₂, Zr0₂, Ru, Pt, Ir et Ir0₂, seuls ou en mélange. Ces matériaux sont souvent préparés à partir de précurseurs organométalliques en poudre mis en solution liquide dans un solvant approprié, puis vaporisés. Avec de tels gaz issus de solutions de composés solides ayant une température de vaporisation différente de celle du solvant, le risque de colmatage d'une installation classique est relativement élevé soit par condensation, soit par décomposition du produit solide.

La présente invention sera mieux comprise à la lecture de la description détaillée de quelques modes de réalisation pris à titre d'exemples nullement limitatifs et illustrés par les dessins annexés, sur lesquels :
- les figures 1 et 2 sont des vues en coupe axiale selon deux plans sécants d'une chambre de traitement ;
- la figure 3 est une vue de détail de la paroi supérieure de la chambre de traitement des figures 1 et 2 ;
- les figures 4 et 5 sont des vues de détail de la figure 3 ;
- la figure 6 est une vue en perspective d'une partie de l'élément chauffant ;
- la figure 7 est une vue en perspective du couvercle de l'anneau de pompage ; et
- la figure 8 est une vue en perspective de l'anneau de pompage des gaz.

Dans les années 1990, on a utilisé des chambres à vide pour le dépôt chimique en phase vapeur avec des éléments chauffants électriques, une entrée de gaz réactif et une alimentation en gaz de purge.

Ensuite, on a cherché à limiter les effets des gaz réactifs sur les parois de la chambre en prévoyant une couche anti corrosion en matériau réfractaire résistant aux attaques chimiques des gaz pour conserver les propriétés réfléchissantes de la paroi interne de la chambre de réaction.

Plus récemment, on a cherché à introduire deux gaz réactifs dans une chambre de traitement au moyen d'un ensemble de distribution de gaz en nickel brasé.

Toutefois, la Demanderesse s'est rendu compte d'un problème ignoré jusqu'à présent, de colmatage de la paroi supérieure par dépôt de matériaux pulvérulents. Les matériaux pulvérulents peuvent provenir des gaz réactifs susceptibles de porter de tels matériaux, ou encore d'une réaction de gaz réactifs entre eux, d'une condensation de gaz réactifs, etc.

Par ailleurs, la Demanderesse s'est aperçue qu'il était important de favoriser la régularité des lignes de flux gazeux dans la chambre afin d'obtenir un dépôt d'épaisseur homogène sur toute la surface du substrat.

Pour une description générale d'une chambre de traitement, on peut se reporter aux documents WO 03/060185 et US 2006/21703.

L'élément de chauffage par fluide caloporteur permet d'éviter les interférences électriques lors de la génération d'un plasma au moyen de la mise sous tension à une fréquence choisie de la paroi supérieure. L'élément de chauffage peut être disposé sur la paroi supérieure ou sur une pièce intercalaire pour chauffer ladite paroi supérieure et les entrées de gaz.

Le dispositif peut comprendre au moins un générateur haute fréquence pourvue d'une sortie reliée à la paroi supérieure. La masse du générateur haute fréquence peut être reliée au support de substrat. L'élément chauffant peut être inactif électriquement. La paroi supérieure est isolée par rapport au support de plaquette et aux parois latérales de la chambre de façon à pouvoir appliquer une tension entre la paroi supérieure et le support de plaquette.

Le support de substrat peut comprendre au moins un élément chauffant pour chauffer ledit substrat ainsi qu'un conducteur pouvant être relié à la masse. On peut ainsi contrôler le profil de température du support de substrat.

Le nombre de canaux de la paroi supérieure de chambre est supérieur à 500, par exemple de l'ordre de 700 pour un substrat à traiter de 200mm de diamètre.

La première entrée de la paroi supérieure de chambre est reliée à une première source de gaz et la deuxième entrée est reliée à une deuxième source de gaz.

La première entrée de la paroi supérieure peut être reliée à une source de gaz et la deuxième entrée peut être reliée à un évaporateur.

Un couvercle peut comprendre un corps conducteur, une paroi supérieure de chambre assurant la répartition des gaz, un élément chauffant et un isolant par rapport au support de substrat. L'isolant peut être disposé sous la forme d'un anneau en contact avec un corps de chambre. L'élément chauffant est protégé contre le parasitage RF. La protection peut être intrinsèque, par exemple avec une conduction thermique, par exemple réalisée par un fluide caloporteur électriquement isolant, ou un rayonnement, par exemple infrarouge, à distance assurant un découplage, ou de construction, par exemple un boîtier isolant et résistant à la chaleur dans lequel une résistance est disposée. Dans le cas d'un fluide caloporteur, l'énergie peut être fournie par une résistance électrique distante peu soumise aux radiations RF.

La paroi supérieure peut comprendre une pluralité de plots formant les premiers canaux. Les plots peuvent être montés en force dans la paroi supérieure. On obtient une excellente étanchéité.

L'anneau d'évacuation des gaz ou anneau de pompage peut comprendre au moins une partie en matériau électriquement isolant. Ledit anneau peut être réalisé de façon monobloc. Ledit anneau peut comprendre une partie supérieure à base de céramique ou revêtue de céramique et une partie inférieure. La partie inférieure peut être conductrice électriquement. La partie inférieure peut être réalisée à base d'alliage léger.

L'anneau d'évacuation de gaz peut comporter au moins dix ouvertures en communication avec la chambre, réparties sur la circonférence de l'anneau de façon que le champ vectoriel de vitesse d'évacuation des gaz soit de symétrie axiale par rapport à l'axe vertical de la chambre et que l'écoulement des gaz soit de nature laminaire dans la gamme de débit envisagée. L'anneau d'évacuation des gaz, la paroi supérieure de la chambre et l'élément de chauffage peuvent être parallèles.

Le dispositif peut comprendre une pièce isolante entre la paroi supérieure et un corps de chambre.

Dans le mode de réalisation représenté sur les figures, le dispositif de traitement référencé 1 dans son ensemble comprend un corps 2 définissant une cavité sur une face et un couvercle 3 fermant ladite cavité sur ladite face pour former une chambre 4. Dans la chambre 4, est prévu un support 5 muni d'une surface supérieure 5a destinée à supporter un substrat à traiter, par exemple par dépôt. Le support 5 peut comprendre un pied 6 et un plateau 7. Le pied 6 peut être en saillie à travers une ouverture 2a du corps 2 du côté opposé au couvercle 3. Le pied 6 peut se prolonger à l'opposé du plateau 7, de façon non représentée et être muni de moyens de déplacement, en rotation et/ou en translation. Le support 5 est réalisé en un matériau isolant contenant une électrode, par exemple à base d'AlN comme isolant et de Mo pour l'électrode. Le support 5 peut être muni d'un organe de contrôle thermique 55, par exemple du type décrit dans le document EP 0 619 381, auquel le lecteur est invité à se reporter. L'organe 55 peut être chauffant et/ou refroidissant.

Le couvercle 3 comprend une pluralité d'éléments de forme générale circulaire. Les éléments du couvercle 3 peuvent être disposés sensiblement parallèlement les uns aux autres. Le couvercle 3 peut assurer des fonctions d'étanchéité, d'introduction d'une pluralité de gaz, de chauffage desdits gaz et d'électrode pour pouvoir générer un champ électrique dans la chambre 4. Le couvercle 3 comprend une partie inférieure 9 et une partie principale 10.

Le couvercle 3 repose sur un bord supérieur du corps 2. Plus précisément, la partie inférieure 9 du couvercle 3 présente une forme générale de disque plat reposant sur une surface supérieure de la partie principale 8, formant partie haute du corps 2. La partie principale 8 peut être réalisée à base d'alliage léger. La partie inférieure 9 du couvercle 3 peut être réalisée à base d'alliage léger, par exemple le même.

La partie principale 10 de forme générale circulaire repose sur la partie inférieure 9. La partie principale 10 peut être réalisée en alliage léger. La partie principale 10 est conductrice thermiquement et percée d'un trou central formant une première entrée 11 pour un premier gaz et d' un trou oblique, ménagé à proximité d'un bord extérieur de ladite partie principale 10 et formant une deuxième entrée 12 pour un deuxième gaz.

La partie principale 10 comprend une concavité circulaire 13 ménagée à partir de sa surface principale opposée à la chambre 4. Un élément de chauffage 14 est disposé dans la cavité 13 et comprend une partie inférieure 15 disposée dans le fond de la cavité 13 et une partie supérieure 16. Les parties inférieure 15 et supérieure 16 peuvent être fixées ensemble par des vis 17. Les parties inférieure 15 et supérieure 16 présentent une forme de disque avec un trou central.

Un bossage 10a de la partie principale 10 est en saillie à partir du fond de la cavité 13 en direction opposée à la chambre 4 en passant dans le trou central des parties inférieure 15 et supérieure 16. Le bossage 10a est en retrait par rapport à la surface supérieure de la partie supérieure 16. L'entrée 11 pour le premier gaz est disposée dans le bossage central 10a.

Au-dessus du bossage central 10a, est prévue une rondelle 18 d'isolation électrique et thermique, par exemple en céramique, entre la partie principale 10 et des éléments disposés en amont dans le sens d'écoulement du premier gaz. Un raccord 19 assure la liaison entre la rondelle 18 et une conduite 20 d'alimentation en premier gaz. Le raccord 19 peut être vissé à la rondelle 18. Des joints d'étanchéité, par exemple des joints circulaires peuvent être disposés entre la rondelle 18 et le bossage 10a d'une part, et entre le raccord 19 et la rondelle 18 d'autre part.

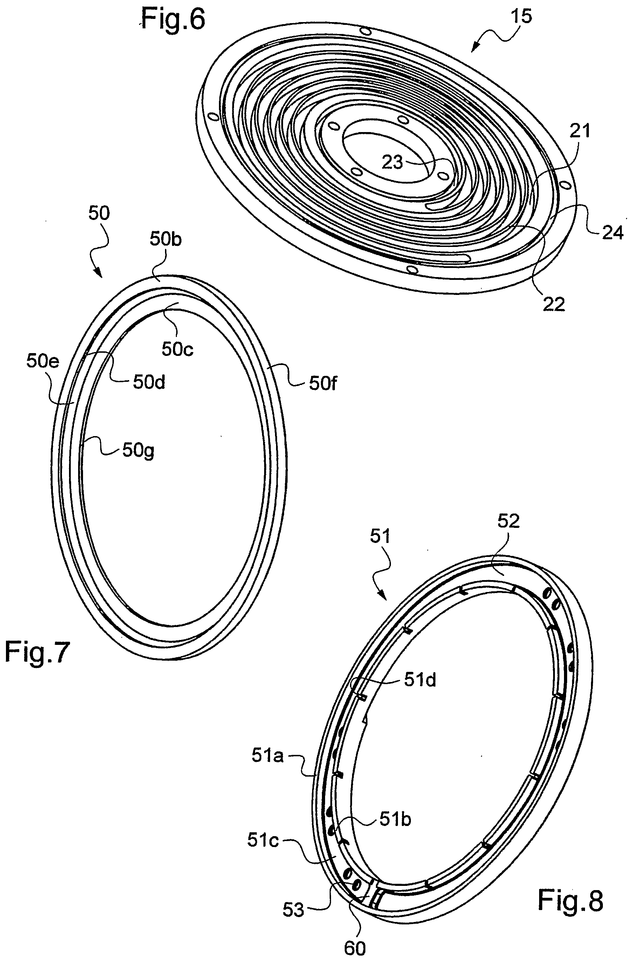

Comme on le voit plus particulièrement sur la figure 6, la partie inférieure 15 de l'élément de chauffage 14 présente un canal spiralé 21 de section sensiblement rectangulaire et formé sur une pluralité de tours entre une extrémité de petit diamètre et une extrémité de grand diamètre. Le canal 21 permet la circulation d'un fluide caloporteur à une température comprise par exemple entre 50° et 300°. Le fluide caloporteur peut comprendre une huile silicone ou un composé perfluoré. Les spires du canal spiralé 21 sont séparées par une paroi spiralée 22 d'épaisseur radiale inférieure à la dimension radiale du canal 21. La plaque supérieure 16 est munie d'une entrée et d'une sortie de fluide caloporteur, non représentées se raccordant auxdites extrémités. La partie inférieure 15 peut être réalisée en un matériau conducteur thermiquement, par exemple à base d'aluminium ou de cuivre. La partie supérieure 16 peut être réalisée en un matériau de conductivité thermique inférieure à celle du matériau de la partie inférieure 15, par exemple un acier inoxydable notamment de type 316L.

Deux gorges annulaires 23 de petit diamètre et 24 de grand diamètre sont ménagées dans la partie inférieure 15 en étant ouvertes du même côté que le canal spiralé 21. Des joints d'étanchéité peuvent être disposés dans les rainures annulaires 23 et 24 entourant radialement le canal spiralé 21. On assure ainsi une excellente étanchéité du canal 21 fermé par la partie supérieure 16.

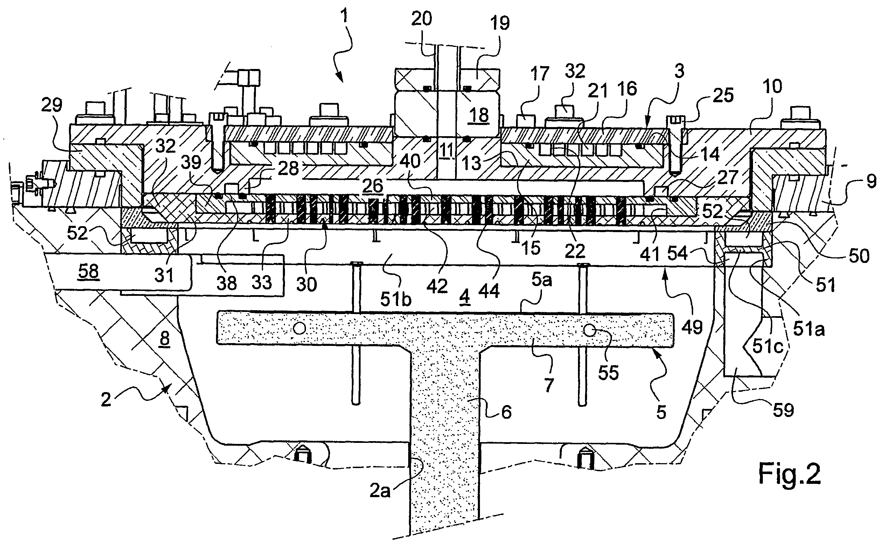

Des vis 25 sont prévues pour fixer la partie supérieure 16 de l'élément chauffant 14 à la partie principale 10 du couvercle 3, voir figure 2. La partie inférieure 15 est ainsi serrée entre le fond de la concavité 13 et la partie supérieure 16 assurant l'étanchéité du canal spiralé 21 entre les parties inférieure 15 et supérieure 16 de l'élément chauffant 14.

À partir de la surface de la partie principale 10 du couvercle 3, opposée à l'élément chauffant 14, est ménagée une concavité 26 centrée sur l'axe du couvercle 3 et en communication de fluide avec l'entrée 11 du premier gaz.

Par ailleurs, une rainure annulaire 27 est ménagée dans la partie principale 10 du couvercle 3 à partir de la surface opposée à l'élément chauffant 14. La rainure annulaire 27 est en communication de fluide avec l'entrée 12 pour le deuxième gaz. La rainure annulaire 27 est séparée de la concavité centrale 26 par un bourrelet annulaire 28 faisant partie de la partie principale 10, la concavité centrale 26 étant ainsi entourée par le bourrelet 28 et par la rainure 27.

Le couvercle 3 comprend également un anneau isolant 29 disposé à proximité du bord extérieur de la partie principale 10. L'anneau 29 est isolant électriquement, notamment par rapport à la partie inférieure 9 du couvercle 3. L'anneau isolant 29 présente une section en L avec une surface supérieure et un alésage en contact avec la partie principale 10 du couvercle 3, une surface extérieure de grand diamètre en contact avec la partie inférieure 9 du couvercle 3. L'alésage est également en contact avec une paroi supérieure 30 de la chambre 4 décrite ci-après. L'anneau isolant 29 présente une paroi annulaire inférieure en contact avec un anneau d'évacuation des gaz 31 décrit ci-après. La partie principale 10 et l'anneau isolant 29 du couvercle 3 peuvent être fixés à la partie inférieure 9 par des vis 32. Le corps 2 est séparé de la partie principale 10 et de la paroi 30 par l'anneau isolant 29. L'anneau isolant 29 peut être à base de céramique de type Al₂O₃.

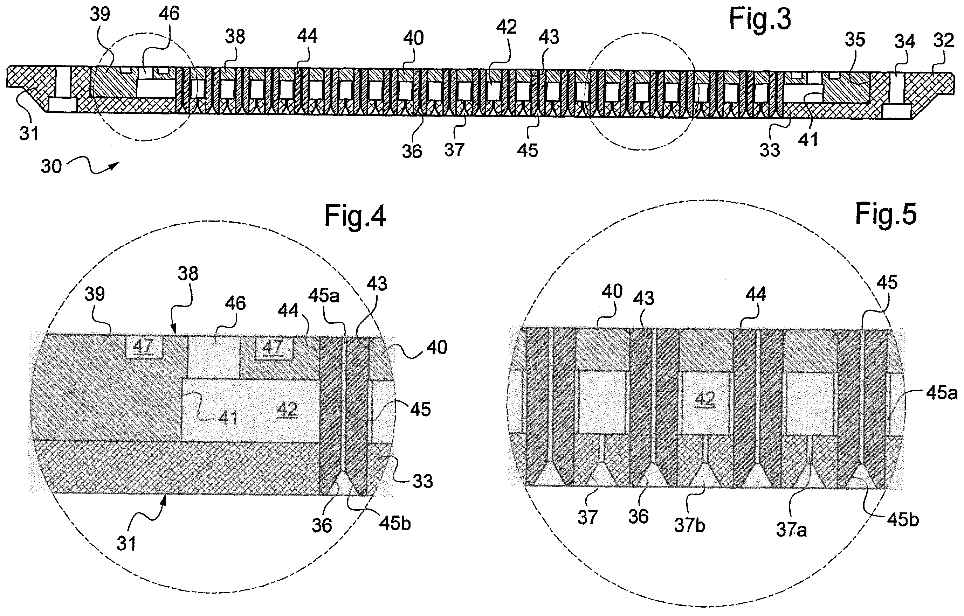

La paroi supérieure 30 est maintenue entre une surface inférieure de la partie principale 10 du couvercle 3 et l'anneau d'évacuation des gaz 49. La paroi supérieure 30 est visible plus en détail sur les figures 3 à 5 et présente une forme générale annulaire. La paroi supérieure 30 comprend un corps 31 comprenant un bord extérieur 32, et une plaque centrale 33 d'épaisseur inférieure au bord extérieur 32. Des perçages 34 sont ménagés dans le bord extérieur 32, notamment en vue de la fixation par des vis non représentées à la partie principale 10 du couvercle 3. Le corps 31 est monobloc. Le corps 31 comprend un alliage léger, conducteur thermiquement.

En raison de la différence d'épaisseur entre la plaque centrale 33 et le rebord extérieur 32, une concavité 35 est formée du côté opposé à la chambre 4. Dans la plaque centrale 33, sont ménagés des trous traversants d'au moins deux types. Des trous 36 présentent une section sensiblement constante. Des trous 37 présentent une partie de petit diamètre 37a au voisinage de la concavité 35 et une partie évasée 37b tronconique à l'opposé de la concavité 35, de diamètre croissant en s'éloignant de ladite concavité 35. Les trous 36 et les trous 37 sont alternés, par exemple disposés sous forme de damier, en carré ou en quinconce. Les trous 36 et 37 peuvent être en nombre important, par exemple compris entre 500 et 1500. Le diamètre des trous 36 est supérieur au diamètre des trous 37.

La paroi supérieure 30 comprend également une contre-plaque 38 comprenant un bord extérieur 39 et une partie centrale 40. La partie centrale 40 est d'épaisseur inférieure au bord extérieur 39 ménageant ainsi une concavité 41 orientée du côté de la plaque centrale 33. Le bord extérieur 39 de la contre-plaque 38 est ajusté dans la concavité 35 du corps 31 formant ainsi une chambre de répartition 42 entre la plaque centrale 33 et la contre-plaque 38. La partie centrale 40 de la contre-plaque 38 est percée d'une pluralité de trous traversants 43 alignés avec les trous 36 de la plaque 33. Au contraire, la partie centrale 40 est pleine en regard des trous 37 de la plaque 33.

La paroi supérieure 30 comprend une pluralité de plots 44 de longueur axiale sensiblement égale à l'épaisseur du corps 31. Chaque plot 44 est monté dans un trou 36 de la plaque centrale 33 et dans un trou 43 de la partie centrale 40. Chaque trou 36 et chaque trou 43 est muni d'un plot 44. À défaut, un trou 36 ou un trou 43 restant peut être muni d'un bouchon non représenté. Le plot 44 se présente sous la forme d'une pièce massive munie d'une surface extérieure cylindrique de révolution, d'une surface supérieure sensiblement alignée avec la surface supérieure du corps 31 et d'un trou traversant 45.

Le plot 44 est monté à force dans le trou 36 et dans le trou 43, par exemple par emmanchement. Le montage peut être effectué à l'aide d'une presse. Pour faciliter l'emmanchement, le plot 43 peut être muni d'un léger chanfrein à son extrémité inférieure au voisinage de sa surface extérieure. Dans une variante, le plot 44 est brasé avec la plaque 33 et la contre-plaque 38. Toutefois, le montage par emmanchement serré est préféré dans le but de conserver les dimensions géométriques du corps 31 et de la contre-plaque 38. L'emmanchement serré assure une excellente étanchéité.

Le trou traversant 45 met en communication de fluide la chambre 26 ménagée sur la face inférieure de la partie principale 10 du couvercle 3 et la chambre 4 tout en maintenant une étanchéité par rapport à la chambre 42. Le plot 44 peut être une pièce massive réalisée en alliage métallique, par exemple à base d'alliage léger, conducteur thermiquement. Le trou 45 comprend une partie cylindrique 45a de petit diamètre s'étendant sur la majeure partie de la longueur du plot 44 à partir de la surface supérieure du corps 31 débouchant dans la chambre 26, et une partie tronconique 45b débouchant dans la chambre 4. La partie cylindrique 45a du trou 45 peut présenter un diamètre sensiblement égal au diamètre de la partie cylindrique 37a du trou 37 ménagé dans la plaque centrale 33 du corps 31. On entend ici par « sensiblement égal », égal à plus ou moins 10% près, préférablement plus ou moins 5% près.

La partie tronconique 45b du trou 45 peut présenter des dimensions sensiblement égales à celles de la partie tronconique 37b du trou 37.

En d'autres termes, la paroi supérieure 30 comprend une pluralité de trous 45 formant des premiers canaux de communication entre l'entrée 11 pour le premier gaz et la chambre 4 par l'intermédiaire de la chambre 26. La chambre 26 assure une répartition du débit du premier gaz dans les trous 45.

Comme on le voit plus particulièrement sur la figure 4, la chambre 42 est munie d'une entrée 46, au droit de la gorge 27, sous la forme d'un trou traversant la partie centrale 40 de la contre-plaque supérieure 38 à proximité du rebord 39. Autour de la gorge 27, deux rainures annulaires 47 sont ménagées à partir de la surface supérieure de la contre-plaque 38 pour y loger deux joints d'étanchéité 48. Les joints d'étanchéité 48 sont en contact avec la surface inférieure dé la partie principale 10 du couvercle 3. Le trou 46 débouche dans la rainure annulaire 27 ménagée à partir de la surface inférieure de la partie principale 10 du couvercle 3 autour de la chambre 26, la rainure 27 étant en communication de fluide avec l'entrée 12 pour le deuxième gaz. Sur la figure 4, un seul trou 46 est visible.

Afin de favoriser un écoulement le plus homogène possible du deuxième gaz provenant de l'entrée 12 et circulant dans la rainure 27, une pluralité de trous 46 peuvent être percés à travers la partie centrale 40. Le deuxième gaz traverse le ou les trous 46 et se répand dans la chambre 42. Le deuxième gaz passe ensuite dans les trous 37 percés dans la plaque centrale 33 et pénètrent dans la chambre de traitement 4. On parvient ainsi à conserver les premier et deuxième gaz séparés en amont de la chambre 4 dans le sens d'écoulement desdits premier et deuxième gaz. On évite ainsi une réaction chimique entre certains constituants des premier et deuxième gaz susceptibles d'être néfaste à l'étape de traitement du substrat ou encore aux dispositifs de traitement 1, notamment par colmatage.

L'élément chauffant 14 permet de maintenir les premier et deuxième gaz, notamment dans les entrées 11 et 12 dans la chambre 26 et dans la rainure 27 à une température suffisante pour éviter les phénomènes de condensation. Par ailleurs, la contre-plaque supérieure 38 de la paroi supérieure 30 peut être réalisée en un matériau bon conducteur de la chaleur, par exemple à base d'alliage léger d'aluminium, ce qui permet de maintenir ladite contre-plaque 38 également à une température élevée, par contact avec la partie principale 10 du couvercle 3 et conduction thermique. La partie inférieure du corps 31 peut également être réalisée en un matériau présentant une bonne conduction thermique, ce qui permet de maintenir la chambre 42 à une température élevée.
L'anneau d'évacuation des gaz 49 est monté sur une surface annulaire 8a du corps 8 sensiblement parallèle au couvercle 3 et dans une surface axiale circulaire 8b formant un alésage. L'anneau d'évacuation des gaz 49 est également en contact avec l'anneau isolant 29 et avec une surface inférieure du corps 31 de la paroi supérieure 30. L'anneau d'évacuation des gaz peut être réalisé de façon monobloc ou en plusieurs parties. L'anneau 49 est disposé axialement entre la paroi supérieure 30 et le support 5.

Dans le mode de réalisation représenté, l'anneau 49 comprend une partie supérieure 50 illustrée sur la figure 7 et une partie inférieure 51 illustrée sur la figure 8. La partie supérieure 50 se présente sous la forme d'une pièce annulaire comprenant une surface inférieure 50a plane, une surface supérieure de grand diamètre 50b en contact avec l'anneau isolant 29, et une surface supérieure de petit diamètre 50c en contact avec la paroi supérieure 30, l'épaisseur axiale de la partie supérieure 50 étant plus élevée au droit de la surface supérieure de grand diamètre 50b qu'au droit de la surface supérieure de petit diamètre 50c. Une courte surface axiale 50d et une surface tronconique 50e relient les surfaces 50b et 50c. La partie supérieure 50 comprend également une surface extérieure axiale 50f en contact avec l'alésage 8b du corps 8 et une surface intérieure 50g de faible dimension axiale. La partie supérieure 50 peut être réalisée à base de céramique, de type Al₂O₃ ou d'alliage léger revêtu de céramique, de type aluminium avec un revêtement de type Al₂O₃.

La partie supérieure 50 sert d'entretoise entre l'anneau isolant 29 et la partie inférieure 51, ainsi que d'isolant entre la partie principale 10 du couvercle 3 et la partie inférieure 51 de l'anneau 49.

La partie inférieure 51 présente une forme générale annulaire à section en H. La partie inférieure 51 comprend une paroi extérieure 51a, une paroi intérieure 51b et une paroi de liaison 51c de forme générale radiale. La paroi intérieure 51b présente une pluralité d'encoches 51d mettant en communication la chambre 4 du côté intérieur de ladite paroi intérieure 51b et un canal de forme générale annulaire 52 formé entre les parois extérieure 51a, intérieure 51b, de liaison 51c et la surface inférieure 50a de la partie supérieure 50. Les encoches 51d sont circonférentiellement régulièrement réparties pour permettre une évacuation avec aspiration de gaz suffisamment homogène, à symétrie axiale et à écoulement laminaire dans la gamme de débit envisagée. On introduit ainsi des gaz par les trous 37, 45 de la paroi supérieure 30, lesdits trous étant disposés sensiblement au centre de la chambre 4 et on évacue les gaz par les encoches 51d disposés à la périphérie de la chambre 4, ce qui permet de régulariser les lignes d'écoulement de fluide dans la chambre 4.

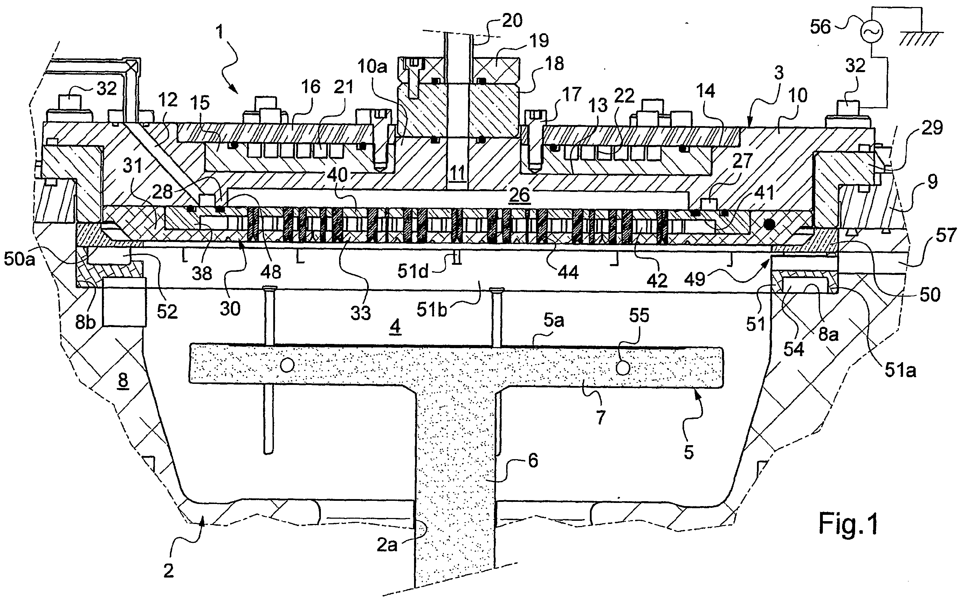

La paroi de liaison 51c est percée d'une pluralité de trous de communication 53. La paroi de liaison 51c est disposée sensiblement à mi-hauteur des parois extérieure 51a et intérieure 51b. Un canal inférieur 54 est formé entre les parois intérieure 51a et extérieure 51b, la paroi de liaison 51c et la surface annulaire 8a du corps 8. Les trous 53 mettent en communication les canaux supérieur 52 et inférieur 54. Le canal inférieur 54 est en communication avec une sortie d'évacuation de gaz 59 ménagée dans le corps 8, voir figure 2. Par ailleurs, un trou 57 (voir figure 1) est ménagé dans le corps 8 et dans un renflement 60 de forme sensiblement rectangulaire, en saillie dans le canal 52 à partir de la paroi de liaison 51c (voir figure 8), pour permettre d'observer l'intérieur de la chambre lors de la création d'un plasma dans la chambre 4, par exemple à l'aide d'un spectromètre d'émission optique. Le trou 57 est bouché en sortie du corps 8 (non visible sur la figure 1) par une vitre traitée anti-UV pour assurer l'étanchéité de la chambre 4 à ce niveau. Une ouverture 58 est ménagée dans le corps 8 pour permettre d'amener le substrat au centre de la chambre 4 sur le support 5 via une chambre de transfert sous vide, éventuellement munie d'un robot, non représentée sur la figure. Cette ouverture est réalisée de telle sorte qu'elle ne gêne pas le positionnement de l'anneau d'évacuation des gaz 49.
Dans un mode de réalisation, la partie supérieure 50 de l'anneau d'évacuation de gaz 49 est réalisée en un matériau isolant électriquement. La partie principale 10 du couvercle 3, l'élément chauffant 14 et la paroi supérieure 30 de la chambre 4 sont ainsi isolés électriquement par rapport aux autres éléments du dispositif de traitement 1 par la rondelle isolante 18, l'anneau isolant 29 et la partie supérieure 50 de l'anneau d'évacuation des gaz. On peut ainsi appliquer une tension choisie à la partie principale 10 et à la paroi supérieure 30, par exemple une tension alternative sous fréquence élevée, tandis que le support 5 est mis à la masse.

L'application d'une tension élevée permet une polarisation favorisant la création d'un plasma dans la chambre 4. La liaison électrique entre le couvercle 3 et une alimentation à haute tension via un dispositif d'adaptation d'impédance peut être effectuée par une tresse métallique, par exemple en cuivre fixée par l'une des vis 32.

Le dispositif de traitement peut ainsi mettre en oeuvre des températures adaptées aux gaz utilisés pour les nouvelles générations de dispositifs réalisés sur des substrats, notamment des solutions vaporisées de précurseurs solides ou bien des gaz présentant une certaine tendance à la condensation ou au dépôt de résidus solides.

L'élément chauffant 14 à fluide caloporteur circulant dans le canal 21 inactif d'un point de vue électrique est compatible avec l'application d'une tension électrique au couvercle 3. L'élément chauffant 14 permet de maintenir la partie principale 10 du couvercle 3 à une température supérieure à la température de condensation la plus élevée des gaz introduits dans la chambre 4, ce qui permet de réduire les risques de condensation ou de dépôt. L'application d'une tension électrique peut servir à générer un plasma qui active la réaction chimique de dépôt et peut également servir à effectuer un nettoyage in-situ des parois de la chambre. Les interférences entre l'alimentation électrique et l'élément chauffant 14 sont évitées grâce au chauffage par fluide caloporteur. Par ailleurs, la température de dépôt peut être contrôlée par l'organe de chauffage 55 monté dans le plateau 7 du support 5. L'organe de chauffage 55 permet de maintenir le substrat à une température choisie et également les gaz dans la chambre 4 à une température choisie. On peut injecter simultanément au moins deux gaz réactifs, un par entrée, dans la chambre.

## Revendications

1. Dispositif de traitement (1) de substrats, comprenant une chambre (4) à pression et température contrôlées, un support (5) de substrat disposé dans la chambre (4), la chambre (4) comprenant une entrée de gaz et une paroi supérieure (30) de chambre munie d'une pluralité de premiers canaux (45) reliés à une première entrée (11) et une pluralité de deuxièmes canaux (37) reliés à une deuxième entrée (12), les premiers et deuxièmes canaux débouchant dans la chambre (4) et étant répartis régulièrement dans la paroi supérieure (30), le dispositif de traitement (1) comprenant un élément de chauffage (14) capable de chauffer la paroi supérieure (30), et un anneau (49) d'évacuation de gaz disposé entre la paroi supérieure (30) et le support (5) de substrat, la paroi supérieure (30) étant conductrice électriquement et isolée par rapport au support (5) de substrat de façon à pouvoir appliquer une tension entre la paroi supérieure (30) et le support (5) de substrat,
l'élément de chauffage (14) étant disposé au-dessus de la paroi supérieure (30) pour chauffer ladite paroi supérieure (30) et les entrées (11, 12),
**caractérisé en ce que** le dispositif comprend un corps (2) définissant une cavité sur une face et un couvercle (3) fermant ladite cavité sur ladite face pour former la chambre (4), le couvercle (3) comprenant une partie inférieure (9) et une partie principale (10) reposant sur la partie inférieure (9), la paroi supérieure (30) étant maintenue entre une surface inférieure de la partie principale (10) du couvercle (3) et l'anneau d'évacuation des gaz (49),
la partie principale (10) du couvercle (3) comprenant une concavité circulaire (13) ménagée à partir de sa surface principale opposée à la chambre (4),
l'élément de chauffage (14) étant disposé dans ladite concavité circulaire (13).

2. Dispositif selon la revendication 1 dans lequel au moins une des entrées (11, 12) est reliée en amont à un évaporateur.

3. Dispositif selon l'une des revendications précédentes, comprenant au moins un générateur haute fréquence (56) comprenant une sortie reliée à la paroi supérieure (30), la masse du générateur haute fréquence étant reliée au support (5) du substrat.

4. Dispositif selon l'une des revendications précédentes, dans lequel le support (5) du substrat comprend au moins un élément à température dirigée (55) pour contrôler la température dudit substrat.

5. Dispositif selon l'une des revendications précédentes, dans lequel la paroi supérieure (30) comprend une pluralité de plots (44) formant les premiers canaux (45).

6. Dispositif selon la revendication 5, dans lequel les plots (44) sont montés en force dans la paroi supérieure (30).

7. Dispositif selon l'une des revendications précédentes, dans lequel ledit anneau (49) d'évacuation des gaz comprend au moins une partie en matériau électriquement isolant.

8. Dispositif selon la revendication 7, dans lequel ledit anneau est réalisé de façon monobloc.

9. Dispositif selon la revendication 7, dans lequel ledit anneau (49) comprend une partie supérieure (50) à base de céramique ou revêtue de céramique et une partie inférieure (51).

10. Dispositif selon l'une des revendications précédentes, dans lequel l'anneau (49) d'évacuation de gaz comporte au moins dix ouvertures (51d) en communication avec la chambre (4), réparties sur la circonférence de l'anneau de façon que le champ vectoriel de vitesse d'évacuation des gaz soit de symétrie axiale par rapport à l'axe vertical de la chambre et que l'écoulement des gaz soit de nature laminaire dans la gamme de débit envisagée.

11. Dispositif selon l'une des revendications précédentes, dans lequel l'anneau (49) d'évacuation de gaz, la paroi supérieure (30) de la chambre et l'élément de chauffage (14) sont parallèles.

12. Dispositif selon l'une des revendications précédentes, dans lequel l'élément de chauffage (14) comprend un fluide caloporteur.

13. Dispositif selon l'une des revendications 1 à 11, dans lequel l'élément de chauffage (14) comprend une lampe infrarouge.

14. Dispositif selon l'une des revendications 1 à 11, dans lequel l'élément de chauffage (14) comprend une résistance isolée dans un boîtier à base de céramique.

15. Procédé de traitement de substrats dans la chambre (4) d'un dispositif selon l'une des revendications précédentes, un substrat étant supporté par le support (5) dans la chambre, dans lequel:
- on chauffe les entrées (11, 12) de gaz à une température supérieure à une température de condensation, le chauffage étant réalisé par un fluide caloporteur;
- on injecte des gaz par lesdites entrées, les gaz traversant la paroi supérieure (30) de la chambre disposée sous les entrées, la traversée étant effectuée par des trous (45, 37) distincts selon la nature du gaz et pénétrant dans la chambre, les trous étant régulièrement répartis ;
- si l'on veut générer un plasma, on applique à la paroi supérieure une tension électrique à haute fréquence par rapport audit support.

## Patentansprüche

1. Vorrichtung (1) zur Behandlung von Substraten, umfassend eine druck- und temperaturgeregelte Kammer (4), einen in der Kammer (4) angeordneten Substratträger (5), wobei die Kammer (4) einen Gaseinlass und eine obere Kammerwand (30), die mit einer Vielzahl erster Kanäle (45), die mit einem ersten Einlass (11) verbunden sind, und einer Vielzahl zweiter Kanäle (37), die mit einem zweiten Einlass (12) verbunden sind, versehen ist, wobei die ersten und zweiten Kanäle in die Kammer (4) münden und in der oberen Wand (30) gleichmäßig verteilt sind, aufweist, wobei die Behandlungsvorrichtung (1) ein Heizelement (14), das imstande ist, die obere Wand (30) zu erwärmen, und einen Gasabzugsring (49), der zwischen der oberen Wand (30) und dem Substratträger (5) angeordnet ist, umfasst, wobei die obere Wand (30) elektrisch leitend und vom Substratträger (5) isoliert ist, derart, dass zwischen der oberen Wand (30) und dem Substratträger (5) eine Spannung angelegt werden kann,
wobei das Heizelement (14) über der oberen Wand (30) angeordnet ist, um die obere Wand (30) und die Einlässe (11, 12) zu erwärmen,
**dadurch gekennzeichnet, dass** die Vorrichtung einen Körper (2), der an einer Seite einen Hohlraum abgrenzt, und eine Abdeckung (3), die den Hohlraum an der Seite verschließt, um die Kammer (4) zu bilden, umfasst, wobei die Abdeckung (3) einen unteren Teil (9) und einen Hauptteil (10), der auf dem unteren Teil (9) ruht, umfasst, wobei die obere Wand (30) zwischen einer unteren Oberfläche des Hauptteils (10) der Abdeckung (3) und dem Gasabzugsring (49) gehalten wird,
wobei der Hauptteil (10) der Abdeckung (3) eine kreisförmige Konkavität (13) aufweist, die von seiner der Kammer (4) gegenüberliegenden Hauptfläche aus ausgearbeitet ist,
wobei das Heizelement (14) in der kreisförmigen Konkavität (13) angeordnet ist.

2. Vorrichtung nach Anspruch 1, wobei mindestens einer der Einlässe (11, 12) stromaufwärts mit einem Verdampfer verbunden ist.

3. Vorrichtung nach einem der vorhergehenden Ansprüche, die mindestens einen Hochfrequenzgenerator (56) umfasst, der einen Ausgang aufweist, der mit der oberen Wand (30) verbunden ist, wobei die Masse des Hochfrequenzgenerators mit dem Träger (5) des Substrats verbunden ist.

4. Vorrichtung nach einem der vorhergehenden Ansprüche, wobei der Träger (5) des Substrats mindestens ein temperaturgeregeltes Element (55) zum Steuern der Temperatur des Substrats aufweist.

5. Vorrichtung nach einem der vorhergehenden Ansprüche, wobei die obere Wand (30) eine Vielzahl metallischer Leisten (44) aufweist, welche die ersten Kanäle (45) bilden.

6. Vorrichtung nach Anspruch 5, wobei die metallischen Leisten (44) in die obere Wand (30) eingepresst sind.

7. Vorrichtung nach einem der vorhergehenden Ansprüche, wobei der Gasabzugsring (49) mindestens einen Teil aus elektrisch isolierendem Material aufweist.

8. Vorrichtung nach Anspruch 7, wobei der Ring einstückig ausgebildet ist.

9. Vorrichtung nach Anspruch 7, wobei der Ring (49) einen oberen Teil (50) auf Keramikbasis oder mit Keramikbeschichtung und einen unteren Teil (51) aufweist.

10. Vorrichtung nach einem der vorhergehenden Ansprüche, wobei der Gasabzugsring (49) mindestens zehn Öffnungen (51d) in Verbindung mit der Kammer (4) aufweist, die derart über den Umfang des Rings verteilt sind, dass das Vektorfeld der Gasabzugsgeschwindigkeit achsensymmetrisch bezüglich der vertikalen Achse der Kammer ist und die Strömung der Gase im vorgesehenen Durchsatzbereich laminar ist.

11. Vorrichtung nach einem der vorhergehenden Ansprüche, wobei der Gasabzugsring (49), die obere Wand (30) der Kammer und das Heizelement (14) parallel sind.

12. Vorrichtung nach einem der vorhergehenden Ansprüche, wobei das Heizelement (14) einen flüssigen Wärmeträger umfasst.

13. Vorrichtung nach einem der Ansprüche 1 bis 11, wobei das Heizelement (14) eine Infrarotlampe umfasst.

14. Vorrichtung nach einem der Ansprüche 1 bis 11, wobei das Heizelement (14) einen isolierten Widerstand in einem Gehäuse auf Keramikbasis umfasst.

15. Verfahren zur Behandlung von Substraten in der Kammer (4) einer Vorrichtung nach einem der vorhergehenden Ansprüche, wobei das Substrat vom Träger (5) in der Kammer getragen wird, wobei:
- man die Gaseinlässe (11, 12) auf eine Temperatur erwärmt, die höher ist als eine Kondensationstemperatur, wobei das Erwärmen mittels eines flüssigen Wärmeträgers erfolgt;
- man Gase durch die Einlässe einbläst, wobei die Gase die obere Wand (30) der unterhalb der Einlässe angeordneten Kammer durchströmen, wobei das Durchströmen durch Löcher (45, 37) erfolgt, die je nach Art des Gases verschieden sind und in die Kammer eindringen, wobei die Löcher gleichmäßig verteilt sind;
- man, wenn man ein Plasma erzeugen möchte, an die obere Wand eine hochfrequente elektrische Spannung gegen den Träger anlegt.

## Claims

1. Device (1) for treating substrates, comprising a chamber (4) having controlled pressure and temperature, a substrate support (5) which is provided in the chamber (4), the chamber (4) comprising a gas inlet and an upper chamber wall (30) which is provided with a plurality of first channels (45) which are connected to a first inlet (11) and a plurality of second channels (37) which are connected to a second inlet (12), the first and second channels opening in the chamber (4) and being regularly distributed in the upper wall (30), the treatment device (1) comprising a heating element (14) which is capable of heating the upper wall (30) and a gas discharge ring (49) which is provided between the upper wall (30) and the substrate support (5), the upper wall (30) being electrically conductive and insulated relative to the substrate support (5) so as to be able to apply a voltage between the upper wall (30) and the substrate support (5),
the heating element (14) being provided above the upper wall (30) in order to heat the upper wall (30) and the inlets (11, 12),
**characterised in that** the device comprises a body (2) which defines a recess in a face and a cover (3) which closes said recess on said face in order to form the chamber (4),
the cover (3) comprising a lower portion (9) and a main portion (10) resting on the lower portion (9),
the upper wall (30) being held between a lower surface of the main portion (10) of the cover (3) and said gas discharge ring (49),
the main portion (10) of the cover (3) comprising a circular concavity (13) which is provided from the main surface thereof opposite the chamber (4),
the heating element (14) being arranged in said circular concavity (13).

2. Device according to claim 1, wherein at least one of the inlets (11, 12) is connected upstream to an evaporator.

3. Device according to any one of the preceding claims, comprising at least one high-frequency generator (56) which comprises an outlet connected to the upper wall (30), the earth of the high-frequency generator being connected to the support (5) of the substrate.

4. Device according to any one of the preceding claims, wherein the support (5) of the substrate comprises at least one element (55) with controlled temperature in order to control the temperature of the substrate.

5. Device according to any one of the above claims, wherein the upper wall (30) comprises a plurality of pins (44) which form the first channels (45).

6. Device according to claim 5, wherein the pins (44) are force-fitted in the upper wall (30).

7. Device according to any one of the preceding claims, wherein said gas discharge ring (49) comprises at least a portion of electrically insulating material.

8. Device according to claim 7, wherein the ring is constructed in one piece.

9. Device according to claim 7, wherein said ring (49) comprises an upper portion (50) based on a ceramic material or coated with a ceramic material and a lower portion (51).

10. Device according to any one of the preceding claims, wherein the gas discharge ring (49) comprises at least ten openings (51d) which are in communication with the chamber (4) and which are distributed over the circumference of the ring so that the vector range of the gas discharge rate has axial symmetry with respect to the vertical axis of the chamber and the flow of the gases is of a laminar type in the envisaged flow range.

11. Device according to any one of the preceding claims, wherein the gas discharge ring (49), the upper wall (30) of the chamber and the heating element (14) are parallel.

12. Device according to any one of the preceding claims, wherein the heating element (14) comprises a heat-exchange fluid.

13. Device according to any one of claims 1 to 11, wherein the heating element (14) comprises an infrared lamp.

14. Device according to any one of claims 1 to 11, wherein the heating element (14) comprises an insulated resistor in a housing based on ceramic material.

15. Process for treating substrates in a chamber (4) having controlled temperature and pressure, a substrate being supported by a support (5) in the chamber, wherein:
- gas inlets (11, 12) are heated to a temperature higher than a condensation temperature, the heating being carried out by a heat-exchange fluid;
- gases are introduced via said inlets, the gases being introduced through an upper wall (30) of the chamber provided under the inlets, the introduction being effected via different holes (45, 37) in accordance with the type of gas and extending into the chamber, the holes being regularly distributed;
- if it is desirable to generate a plasma, a high-frequency electrical voltage is applied to the upper wall in relation to said support.
